# EUROPÄISCHE PATENTSCHRIFT

(11) **EP 4 048 900 B1**
(45) Veröffentlichungstag und Bekanntmachung des Hinweises auf die Patenterteilung: **08.04.2026**
(21) Anmeldenummer: 20807280.1
(22) Anmeldetag: 09.10.2020
(51) Int. Cl.: F04D 19/00, F04D 25/06, F04D 29/42, F04D 25/08, F04D 29/52, H01L 23/467

(54) **ELEKTROGERÄT, INSBESONDERE WECHSELRICHTER, INSBESONDERE UMRICHTER**
ELECTRICAL DEVICE, IN PARTICULAR INVERTER, IN PARTICULAR CONVERTER
DISPOSITIF ÉLECTRIQUE, EN PARTICULIER UN ONDULEUR, EN PARTICULIER UN CONVERTISSEUR

(30) Priorität: 24.10.2019 DE 102019007399
(43) Veröffentlichungstag der Anmeldung: 31.08.2022
(73) Patentinhaber: SEW-EURODRIVE GmbH & Co. KG, 76646 Bruchsal (DE)
(72) Erfinder: JANZER, Rolf, 76646 Bruchsal (DE); SCHÖRNER, Martin, 76646 Bruchsal (DE)
(86) Internationale Anmeldenummer: PCT/EP2020/025451
(87) Internationale Veröffentlichungsnummer: WO 2021/078404

(56) Entgegenhaltungen:
- WO-A1-2017/157529
- TW-A- 201 303 566
- US-A1- 2005 253 467
- US-A1- 2010 202 109

## Beschreibung

Die Erfindung betrifft ein Elektrogerät, insbesondere Wechselrichter, insbesondere Umrichter.

Es ist allgemein bekannt, dass ein Elektrogerät mit einem Lüfter zur Entwärmung vorsehbar ist.

Der Erfindung liegt daher die Aufgabe zugrunde, eine einfache und schnelle Herstellung des Elektrogeräts weiterzubilden.

Aus der EP 2 439 415 A1 ist eine Kabelführung bei einem elektrischen Gerät bekannt.

Aus der US 2015 / 0 351 280 A1 ist eine drehbare Lüfteranordnung bekannt.

Aus der US 2008 / 0 014 085 A1 ist ein Lüftergehäuse mit Kabelbefestigung bekannt.

Aus der DE 20 2014 100 266 U1 ist ein Lüfter mit Lüftergehäuse bekannt.

Aus der DE 10 2014 108 396 A1 ist eine Antennenanordnung mit Lüftereinheit bekannt.

Aus der DE 10 2018 202 889 A1 ist ein Motor mit Luftblasvorrichtung bekannt.

**Aus der** WO 2017/157529 A1 **ist als nächstliegender Stand der Technik ein Elektrogerät bekannt.**

**Aus der** TW 201 303 566 A **ist eine Lüfteranordnung bekannt.**

**Aus der** US 2005/253467 A1 **ist ein Lüfter bekannt.**

**Aus der** US 2010/202109 A1 **ist ein Frequenzumrichter bekannt.**

Erfindungsgemäß wird die Aufgabe bei dem Elektrogerät nach den in Anspruch 1 angegebenen Merkmalen gelöst.

Wichtige Merkmale der Erfindung bei dem Elektrogerät, insbesondere Wechselrichter, insbesondere Umrichter, sind, dass das Elektrogerät einen Kühlkörper und einen Lüfter aufweist,
wobei der Lüfter von einem Basisbereich eines Lüftergehäuses zumindest teilweise umgeben ist,
wobei das Lüftergehäuse einen über einen Verbindungsbereich mit dem Basisbereich verbundenen Führungsbereich für ein Kabel, insbesondere ein Versorgungskabel des Lüfters, aufweist,
wobei das Lüftergehäuse mit seinem Basisbereich, Verbindungsbereich und Führungsbereich zur Führung eines Kabels einteilig, insbesondere einstückig, ausgeführt ist, insbesondere als Kunstsstoffspritzgussteil.

Von Vorteil ist dabei, dass die Zuführung eines Kabels geschützt im Lüftergehäuse selbst ausführbar ist. Somit schützt das Lüftergehäuse das Kabel mechanisch und erhöht auch den elektrischen Isolierabstand. Dabei ist der Führungsbereich weiter ausgedehnt als der Basisbereich, insbesondere erstreckt sich der Führungsbereich weiter vom Verbindungsbereich und vom Basisbereich weg als die größte Ausdehnung des Basisbereichs beträgt.

Somit kragt der Führungsbereich vom Verbindungsbereich aus gesehen auf der vom Basisbereich abgewandten Seite des Verbindungsbereichs weit aus und ist daher geeignet das Kabel zu einem weit entfernten Steckverbinderteil zu führen. Dabei ist der Führungsbereich am Kühlkörper berührend anordenbar. Der Kühlkörper ist mit dem Schutzleiter und/oder mit dem Bezugspotential, insbesondere elektrische Masse, leitend verbunden. Daher ist der Führungsbereich vorzugsweise aus einem Material gefertigt, das einen hohen Isolierabstand zwischen der im Kabel angeordneten elektrischen Leitung und dem Kühlkörper bewirkt.

Bei einer vorteilhaften Ausgestaltung weist der Lüfter einen Elektromotor auf, dessen Rotor um die Drehachse des Lüfters drehbar gelagert ist und dessen Stator mit dem Lüftergehäuse drehfest verbunden ist. Von Vorteil ist dabei, dass der Stator eine Statorwicklung umfasst, die mittels des Kabels versorgbar ist. Der Rotor ist beispielhaft mit einem Dauermagneten bestückt, so dass die Lüfterflügel relativ zum Stator des Lüfters in Drehbewegung versetzbar ist. Der so geförderte Luftstrom ist gerichtet auf die Kühlrippen und strömt zwischen den Kühlrippen hindurch, insbesondere entlang der Erstreckungsrichtung der Kühlrippen.

Gemäß der Erfindung ist der Verbindungsbereich zwischen dem Basisbereich und dem Führungsbereich angeordnet und ist vom Basisbereich zum Führungsbereich sich verjüngend ausgeformt. Von Vorteil ist dabei, dass der im Vergleich zum Basisbereich schmalere Führungsbereich ohne Kerbstellen angebunden ist, insbesondere also eine mechanisch stabile Verbindung ausführbar ist.

Bei einer vorteilhaften Ausgestaltung ist im Führungsbereich das Kabel aufgenommen, welches vom Lüfter durch den Verbindungsbereich und durch den Führungsbereich zu einem Steckverbinderteil geführt ist und ist mit diesem insbesondere elektrisch verbunden,
wobei das Steckverbinderteil auf einer am Kühlkörper befestigten, insbesondere mittels einer Schraube angeschraubten, Leiterplatte des Elektrogeräts bestückt ist. Von Vorteil ist dabei, dass der Lüfter von der Leiterplatte her versorgbar ist. Dabei weist die Leiterplatte die Signalelektronik des Wechselrichters auf, so dass die Signalelektronik pulsweitenmodulierte Ansteuersignale für steuerbare Halbleiterschalter, insbesondere IGBT oder MOSFET, aufweist, die eine Drehspannung bereitstellen, deren Frequenz steuerbar ist. Die Versorgung des Lüfters erfolgt also über die leiterplatte, welche mittels eines mit dem Öffentlichen Wechselstromversorgungsnetz verbundenen Versorgungskabels versorgbar ist.

Gemäß der Erfindung sind am Basisbereich Rastnasen ausgebildet, welche an einem jeweiligen Hinterschnitt eingerastet und/oder eingeklipst sind,
wobei der jeweilige Hinterschnitt an einer am Kühlkörper hervorragenden Rippe ausgebildet ist,
wobei die Rippe entgegengesetzt zur Förderrichtung des vom Lüfter geförderten Luftstroms am Kühlkörper hervorragt. Von Vorteil ist dabei, dass die Rastnasen eine einfache und formschlüssige Befestigung ermöglichen. Außerdem sichern die Rastnasen den Basisbereich auch gegen ein Abziehen entgegengesetzt zu Aufsteckrichtung beim Aufstecken des am Basisbereich ausgeformten Laschenbereichs auf den am Kühlkörper ausgeformten Verdickungsbereich.

Bei einer vorteilhaften Ausgestaltung ist am Basisbereich ein axial hervorstehender Laschenbereich ausgeformt, welcher ein durchgehendes Loch aufweist, durch welches ein an einer Kühlrippe angeformter hervorstehender Verdickungsbereich hindurchragt. Von Vorteil ist dabei, dass eine in mit Ausnahme der Aufsteckrichtung des Laschenbereichs auf den Verdickungsbereich formschlüssige Sicherung des Basisbereichs am Kühlkörper ausführbar ist.

Bei einer vorteilhaften Ausgestaltung ragt am Führungsbereich ein Laschenbereich insbesondere in axialer Richtung, hervor, wobei durch den Laschenbereich ein Dom, insbesondere ein am Kühlkörper hervorstehender Dom, hindurchragt. Von Vorteil ist dabei, dass eine in mit Ausnahme der Aufsteckrichtung des Laschenbereichs auf den Dom formschlüssige Sicherung des Basisbereichs am Kühlkörper ausführbar ist.

Bei einer vorteilhaften Ausgestaltung ist am Führungsbereich eine Rastnase, insbesondere eine parallel zur Drehachse des Lüfters elastisch auslenkbare Rastnase, ausgeformt,
wobei die Rastnase in einen an einer Kante des Kühlkörpers ausgebildeten Hinterschnitt eingreift. Von Vorteil ist dabei, dass auch der Führungsbereich am Kühlkörper verrastbar ist. Dabei sichert diese Rastnase auch das Abziehen des Führungsbereichs entgegengesetzt zur Aufsteckrichtung des Laschenbereichs auf den Dom.

**Erfindungsgemäß** sind am Führungsbereich Begrenzungsbereiche ausgeformt, welche im Führungsbereich aufgenommene Kabel begrenzen,
wobei das Material der Begrenzungsbereiche zwischen Kabel und Kühlkörper angeordnet ist. Von Vorteil ist dabei, dass das Kabel nicht nur mechanisch gehalten, sondern auch mit einem großen Isolationsabstand zum Kühlkörper anordenbar ist und entlang einer Seite des Kühlkörpers führbar ist.

Bei einer vorteilhaften Ausgestaltung ist der Lüfter als Axiallüfter ausgebildet und der vom Lüfter geförderte Luftstrom ist entlang der Kühlrippen gerichtet. Von Vorteil ist dabei, dass eine effiziente Kühlung des Wechselrichters ausführbar ist.

Bei einer vorteilhaften Ausgestaltung ist die am Führungsbereich ausgeformte Rastnase in axialer Richtung eingeklipst, insbesondere an dem Hinterschnitt der Kante,
wobei die am Basisbereich ausgeformten Rastnasen in zur axialen Richtung senkrechter Richtung eingeklipst sind, insbesondere an der am Kühlkörper hervorstehenden Kante. Von Vorteil ist dabei, dass eine verbesserte Sicherung am Kühlkörper ausgeführt ist, da die Wirkrichtungen der Rastnasen, insbesondere also auch die Ebenen ihrer jeweiligen elastischen Auslenkung, nicht parallel zueinander ausgerichtet sind.

Bei einer vorteilhaften Ausgestaltung ragt der am Basisbereich ausgeformte Laschenbereich in axialer Richtung hervor und der am Führungsbereich ausgeformte Laschenbereich ragt in axialer Richtung hervor. Von Vorteil ist dabei, dass beide Laschenbereiche zum Kühlkörper hin hervorragen und somit das Lüftergehäuse am Kühlkörper befestigbar ist. Mittels der Laschenbereiche ist das Lüftergehäuse gleichzeitig auf den Dom und den an einer der Kühlrippen ausgeformten Verdickungsbereich des Kühlkörpers aufsteckbar. Mittels der Rastnasen ist auch das Aufstecken dann durch Einrasten der Rastnasen am Kühlkörper sicherbar, also das Abziehen entgegen der Aufsteckrichtung verhinderbar.

Bei einer vorteilhaften Ausgestaltung sind an den Kühlrippen weitere Verdickungen ausgeformt, welche nicht aus der Kühlrippe hervorragen und/oder welche bündig mit der Kühlrippe ausgeformt sind, insbesondere also nicht hervorragen. Von Vorteil ist dabei, dass die Kühlrippen mechanisch stabilisierbar sind.

Weitere Vorteile ergeben sich aus den Unteransprüchen.

Die Erfindung wird nun anhand von schematischen Abbildungen näher erläutert:

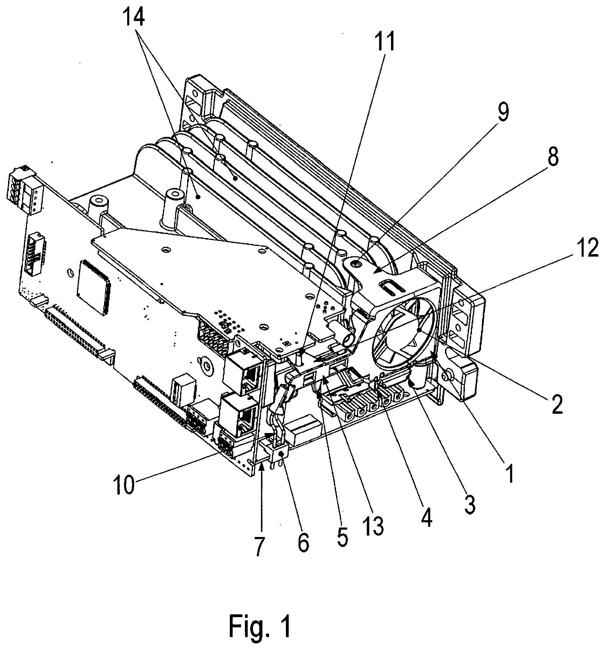

In der Figur 1 ist eine Schrägansicht eines erfindungsgemäßen Wechselrichters, insbesondere Umrichters, bei ausgeblendetem Gehäuse dargestellt.

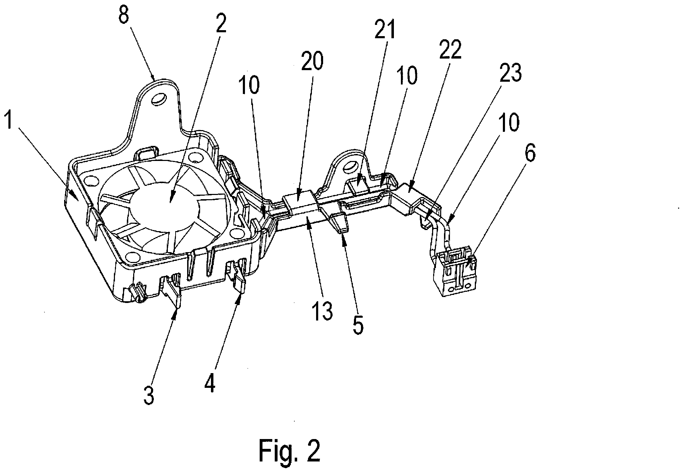

In der Figur 2 ist ein Lüftergehäuse 1 des Wechselrichters dargestellt.

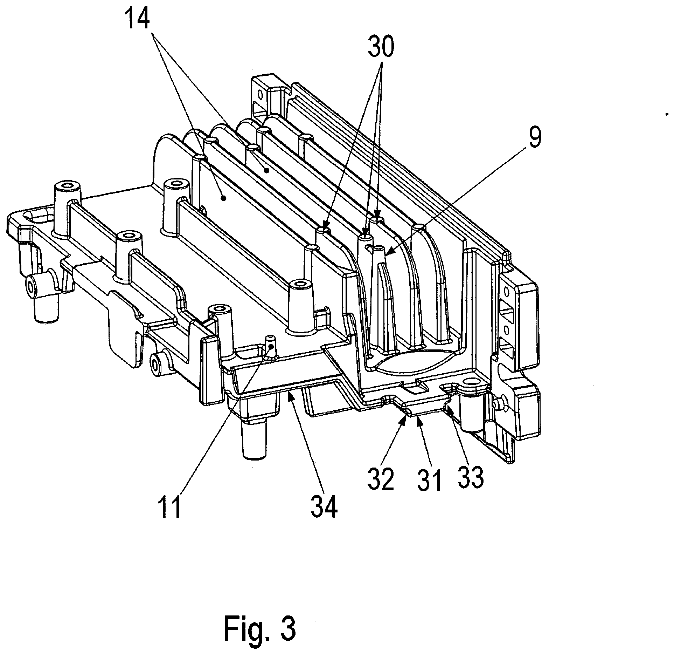

In der Figur 3 ist ein Kühlkörper des Wechselrichters in Schrägansicht dargestellt.

Wie in den Figuren dargestellt, weist der Wechselrichter einen Kühlkörper auf, an welchem eine Leiterplatte 7 angeordnet, insbesondere mittels Schrauben befestigt, ist. Dabei ist die Leiterplatte 7 mehrstückig ausgeführt, wobei die Leiterplattenstücke nicht alle zueinander parallel ausgerichtet sind und somit der Kühlkörper teilweise umgebbar ist von der Leiterplatte 7.

Auf der Leiterplatte 7 ist sowohl eine Signalelektronik als auch eine Leistungselektronik angeordnet. Die Leistungselektronik weist steuerbare Halbleiterschalter auf, welche wärmeleitend mit dem Kühlkörper verbunden sind. Diese Halbleiterschalter sind beispielsweise als IGBT oder MOSFET Schalter ausgeführt und in drei Halbbrücken angeordnet, welche parallelgeschaltet sind. Diese Parallelschaltung ist aus einer Gleichspannungsquelle versorgt, die beispielsweise als netzgespeister Gleichrichter ausführbar ist.

Die Signalelektronik erzeugt Ansteuersignale zur Ansteuerung der Halbleiterschalter, so dass diese pulsweitenmoduliert betreibbar sind.

Der Kühlkörper weist zueinander parallel ausgerichtete Kühlrippen 14 auf, an denen Verdickungen 30 ausgeformt sind, welche bündig mit den Kühlrippen ausgeformt sind, also im Wesentlichen nicht hervorstehen.

Außerdem ist an einer der Kühlrippen 14 eine Verdickung 9 ausgeformt, die aber aus dieser Kühlrippe hervorsteht, so dass eine ein durchgehendes Loch aufweisende Laschenbereich 8 auf derart auf die Verdickung 9 auffädelbar ist, dass der aus der Kühlrippe 14 hervorstehende Bereich der Verdickung 9 in das Loch ragt oder durch das Loch hindurchragt. Somit ist der Laschenbereich 8 formschlüssig gesichert.

Der Laschenbereich 8 ist ein Teilbereich eines Basisbereichs eines Lüftergehäuses 1, welches mit dem Kühlkörper verbunden ist. Der Basisbereich ist im Wesentlichen quaderförmig, den Lüfter umgebend, ausgeformt. Im Basisbereich des Lüftergehäuses 1 ist ein Lüfter 2 drehbar gelagert und von einem Elektromotor angetrieben, wobei der Lüfter 2 einen Luftstrom in bezogen auf die Drehrichtung des Lüfters 2 axialer Richtung fördert. Der Stator des Elektromotors ist drehfest mit dem Basisbereich verbunden und der Rotor des Elektromotors drehbar gelagert um die Drehachse des Lüfters 2.

Das Lüftergehäuse 1 umgibt mit seinem Basisbereich den Lüfter 2 und ist als Kunststoffspritzgussteil einstückig mit einem über einen Verbindungsbereich mit dem Basisbereich verbundenen Führungsbereich 13 ausgebildet, welcher sich in einer zur Erstreckungsrichtung der Kühlrippen 14 senkrechten Richtung erstreckt, insbesondere mehr erstreckt als in Richtung der Kühlrippen 14. Der Verbindungsbereich ist somit zwischen dem Basisbereich und dem Führungsbereich 13 angeordnet. Der Verbindungsbereich verjüngt sich vom Basisbereich herkommend hin zum Führungsbereich 13.

Am Kühlkörper ist eine entgegen der Richtung des vom Lüfter 2 geförderten Luftstroms am Kühlkörper hervorragende Rippe 31 ausgebildet, welche an ihrer vom Lüfter 2 abgewandten Seite zwei voneinander beabstandete Hinterschnitte 32 und 33 aufweist, in welche zwei Rastnasen (3, 4) des Basisbereichs des Lüftergehäuses 1 eingeklipst sind.

Somit ist also die Rastnase 3 senkrecht zur Drehachse des Lüfters 2 elastisch auslenkbar und dadurch in den Hinterschnitt 33 eingeklipst.

Entgegengesetzt gerichtet ist die Rastnase 4 ebenfalls senkrecht zur Drehachse des Lüfters 2 elastisch auslenkbar und dadurch in den Hinterschnitt 34 eingeklipst.

Die Rastnasen 3 und 4 sind näher am Lüfter 2 angeordnet als am Führungsbereich 13.

Am Kühlkörper ist zusätzlich auch ein Dom 11, insbesondere ein aus dem Kühlkörper hervorstehender Dom, ausgebildet.

Das Lüftergehäuse 1 weist einen Führungsbereich 13 auf, an welchem ein Kanal zur Führung eines Kabels, insbesondere des elektrischen Versorgungskabels des Lüfters 2, ausgebildet ist.

Am Führungsbereich 13 sind Begrenzungsbereiche (20, 21, 22, 23) ausgeformt, welche das Kabel 10 im Kanal halten, also begrenzen.

Am Führungsbereich 13 ist auch ein axial hervorstehender Laschenbereich 12 ausgeformt, an dessen Seite, insbesondere dem Kühlkörper zugewandter Seite, eine Rastnase 5 ausgeformt ist, welche an einer Kante 34 des Kühlkörpers, insbesondere an einem an einer Kante 34 des Kühlkörpers ausgeformten Hinterschnitt, eingeklipst ist.

Außerdem ragt ein Dom 11, insbesondere aus dem Kühlkörper hervorstehender Dom 11, durch ein durch den Laschenbereich 12 durchgehendes Loch hindurch, insbesondere so dass der Führungsabschnitt 13 mittels seines Laschenbereichs 12 formschlüssig gehalten ist am Dom 11 des Kühlkörpers.

Auf der Leiterplatte 7 ist ein Steckverbinderteil 6 bestückt, das mit dem Kabel 10 elektrisch verbunden ist. Somit ist der Lüfter 2 von der Leiterplatte 7 her versorgbar.

Die Rastnase 5 ist parallel zur Drehachse des Lüfters 2 elastisch auslenkbar.

Somit ist also der Lüfter 2 am Kühlkörper formschlüssig und mittels Einklipsverbindungen befestigt. Das Kabel 10 ist im Kanal in einem ausreichend großen Isolierabstand zu den sonstigen elektronischen Bauelementen angeordnet.

Das Lüftergehäuse 1 verjüngt sich zu dem Führungsbereich 13 hin, wobei das Lüftergehäuse 1 zusammen mit dem Führungsbereich als einteiliges, also einstückiges, Kunststoffspritzgussteil gefertigt ist.

### Bezugszeichenliste

1 Lüftergehäuse
2 Lüfter
3 Rastnase, insbesondere senkrecht zur Drehachse des Lüfters 2 elastisch auslenkbare Rastnase
4 Rastnase, insbesondere senkrecht zur Drehachse des Lüfters 2 elastisch auslenkbare Rastnase
5 Rastnase, insbesondere parallel zur Drehachse des Lüfters 2 elastisch auslenkbare Rastnase
6 Steckverbinderteil
7 Leiterplatte
8 axial hervorstehender Laschenbereich
9 hervorstehender Verdickungsbereich der Kühlrippe 14
10 Kabel
11 Dom, insbesondere aus dem Kühlkörper hervorstehender Dom
12 axial hervorstehender Laschenbereich
13 Führungsbereich
14 Kühlrippen
20 Begrenzungsbereich
21 Begrenzungsbereich
22 Begrenzungsbereich
23 Begrenzungsbereich
30 Verdickungen
31 Rippe
32 Hinterschnitt
33 Hinterschnitt
34 Kante mit Hinterschnitt

## Patentansprüche

1. Elektrogerät, insbesondere Wechselrichter, insbesondere Umrichter,
wobei das Elektrogerät einen Kühlkörper und einen Lüfter (2) aufweist,
wobei der Lüfter (2) zumindest teilweise von einem Basisbereich eines Lüftergehäuses (1) umgeben ist,
**wobei** das Lüftergehäuse (1) einen über einen Verbindungsbereich mit dem Basisbereich verbundenen Führungsbereich (13) für ein Kabel (10), insbesondere ein Versorgungskabel des Lüfters (2), aufweist,
wobei das Lüftergehäuse (1) mit seinem Basisbereich, Verbindungsbereich und Führungsbereich (13) einteilig, insbesondere einstückig, ausgeführt ist, insbesondere als Kunstsstoffspritzgussteil,
**dadurch gekennzeichnet, dass**
**der Verbindungsbereich zwischen dem Basisbereich und dem Führungsbereich (13) angeordnet ist und vom Basisbereich zum Führungsbereich (13) sich verjüngend ausgeformt ist,** wobei am Führungsbereich (13) Begrenzungsbereiche (20, 21, 22, 23) ausgeformt sind, welche im Führungsbereich (13) aufgenommene Kabel (10) begrenzen, wobei das Material der Begrenzungsbereiche (20, 21, 22, 23) zwischen Kabel (10) und Kühlkörper angeordnet ist,
wobei am Basisbereich Rastnasen (3,4) ausgebildet sind, welche an einem jeweiligen Hinterschnitt (32, 33) eingerastet und/oder eingeklipst sind,
wobei der jeweilige Hinterschnitt (32, 33) an einer am Kühlkörper hervorragenden **Rippe (31) ausgebildet ist,**
**wobei die Rippe (31) entgegengesetzt zur Förderrichtung des vom Lüfter (2) geförderten Luftstroms am Kühlkörper hervorragt.**

2. Elektrogerät nach Anspruch 1,
**dadurch gekennzeichnet, dass**
der Lüfter (2) einen Elektromotor aufweist, dessen Rotor um die Drehachse des Lüfters (2) drehbar gelagert ist und dessen Stator mit dem Lüftergehäuse (1) drehfest verbunden ist.

3. Elektrogerät nach einem der vorangegangenen Ansprüche,
**dadurch gekennzeichnet, dass**
im Führungsbereich (13) das Kabel (10) aufgenommen ist, welches vom Lüfter (2) durch den Verbindungsbereich und durch den Führungsbereich (13) zu einem Steckverbinderteil (6) geführt ist und mit diesem insbesondere elektrisch verbunden ist,
wobei das Steckverbinderteil (6) auf einer am Kühlkörper befestigten, insbesondere mittels einer Schraube angeschraubten, Leiterplatte (7) des Elektrogeräts bestückt ist.

4. Elektrogerät nach einem der vorangegangenen Ansprüche,
**dadurch gekennzeichnet, dass**
am Basisbereich ein axial hervorstehender Laschenbereich (8) ausgeformt ist, welcher ein durchgehendes Loch aufweist, durch welches ein an einer Kühlrippe angeformter hervorstehender Verdickungsbereich (9) hindurchragt.

5. Elektrogerät nach einem der vorangegangenen Ansprüche,
**dadurch gekennzeichnet, dass**
am Führungsbereich (13) ein Laschenbereich (12) insbesondere in axialer Richtung, hervorragt, wobei durch den Laschenbereich ein Dom (11), insbesondere ein am Kühlkörper hervorstehender Dom (11), hindurchragt.

6. Elektrogerät nach einem der vorangegangenen Ansprüche,
**dadurch gekennzeichnet, dass**
am Führungsbereich (13) eine Rastnase (5), insbesondere eine parallel zur Drehachse des Lüfters (2) elastisch auslenkbare Rastnase (5), ausgeformt ist, wobei die Rastnase (5) in einen an einer Kante (34) des Kühlkörpers ausgebildeten Hinterschnitt (32, 33) eingreift.

7. Elektrogerät nach einem der vorangegangenen Ansprüche,
**dadurch gekennzeichnet, dass**
der Lüfter (2) als Axiallüfter ausgebildet ist und der vom Lüfter (2) geförderte Luftstrom entlang der Kühlrippen (14) gerichtet ist.

8. Elektrogerät nach einem der vorangegangenen Ansprüche,
**dadurch gekennzeichnet, dass**
die am Führungsbereich (13) ausgeformte Rastnase (5) in axialer Richtung eingeklipst ist, insbesondere an dem Hinterschnitt (32, 33) der Kante (34) , wobei die am Basisbereich ausgeformten Rastnasen (3, 4) in zur axialen Richtung senkrechter Richtung eingeklipst sind, insbesondere an der am Kühlkörper hervorstehenden Kante (34).

9. Elektrogerät nach einem der vorangegangenen Ansprüche,
**dadurch gekennzeichnet, dass**
der am Basisbereich ausgeformter Laschenbereich in axialer Richtung hervorragt und der am Führungsbereich (13) ausgeformte Laschenbereich in axialer Richtung hervorragt.

10. Elektrogerät nach einem der vorangegangenen Ansprüche,
**dadurch gekennzeichnet, dass**
an den Kühlrippen (14) weitere Verdickungen (30) ausgeformt sind, welche nicht aus der Kühlrippe hervorragen und/oder welche bündig mit der Kühlrippe ausgeformt sind,
insbesondere also nicht hervorragen.

11. Elektrogerät nach einem der vorangegangenen Ansprüche,
**dadurch gekennzeichnet, dass**
der Lüfter (2) zumindest teilweise von dem Verbindungsbereich des Lüftergehäuses (1) umgeben ist.

## Claims

1. Electrical device, in particular an inverter, in particular a converter,
wherein the electrical device has a heat sink and a fan (2), wherein the fan (2) is surrounded at least in part by a base region of a fan housing (1),
wherein the fan housing (1) has a guide region (13) for a cable (10), in particular a power supply cable of the fan (2), said guide region being connected to the base region by way of a connecting region,
wherein the fan housing (1) with its base region, connecting region and guide region (13) is formed as a single part, in particular in one piece, in particular as an injection-molded plastic part,
**characterized in that**
the connecting region is arranged between the base region and the guide region (13) and is shaped so as to taper from the base region to the guide region (13),
wherein bounding regions (20, 21, 22, 23) are formed on the guide region (13), which bounding regions bound cables (10) received in the guide region (13), the material of the bounding regions (20, 21, 22, 23) being arranged between the cables (10) and the heat sink,
wherein latching protrusions (3, 4) are formed on the base region, which latching protrusions are latched and/or clipped onto a respective undercut (32, 33),
wherein the respective undercut (32, 33) is formed on a rib (31) projecting from the heat sink,
wherein the rib (31) projects from the heat sink in a direction opposite to the conveying direction of the airflow conveyed by the fan (2).

2. Electrical device according to claim 1,
**characterized in that**
the fan (2) has an electric motor, the rotor of which is mounted so as to rotate about the axis of rotation of the fan (2), and the stator of which is non-rotatably connected to the fan housing (1) .

3. Electrical device according to any one of the preceding claims,
**characterized in that**
the cable (10) is received in the guide region (13), said cable being guided from the fan (2) through the connecting region and through the guide region (13) to a plug-in connector part (6) and being in particular electrically connected thereto,
wherein the plug-in connector part (6) is mounted on a printed circuit board (7) of the electrical device, said printed circuit board being attached to the heat sink, in particular screwed onto the latter by means of a screw.

4. Electrical device according to any one of the preceding claims,
**characterized in that**
an axially projecting tab region (8) is formed on the base region, said tab region having a through-hole, through which there protrudes a projecting thickened region (9) formed on a cooling fin.

5. Electrical device according to any one of the preceding claims,
**characterized in that**
a tab region (12) projects from the guide region (13), in particular in the axial direction, wherein a dome (11), in particular a dome (11) projecting from the heat sink, protrudes through the tab region.

6. Electrical device according to any one of the preceding claims,
**characterized in that**
a latching protrusion (5), in particular a latching protrusion (5) which is elastically deflectable parallel to the axis of rotation of the fan (2), is formed on the guide region (13), wherein the latching protrusion (5) engages in an undercut (32, 33) formed on an edge (34) of the heat sink.

7. Electrical device according to any one of the preceding claims,
**characterized in that**
the fan (2) is designed as an axial fan, and the airflow conveyed by the fan (2) is directed along the cooling fins (14).

8. Electrical device according to any one of the preceding claims,
**characterized in that**
the latching protrusion (5) formed on the guide region (13) is clipped on in the axial direction, in particular onto the undercut (32, 33) of the edge (34),
wherein the latching protrusions (3, 4) formed on the base region are clipped on in a direction perpendicular to the axial direction, in particular onto the edge (34) projecting from the heat sink.

9. Electrical device according to any one of the preceding claims,
**characterized in that**
the tab region formed on the base region projects in the axial direction, and the tab region formed on the guide region (13) projects in the axial direction.

10. Electrical device according to any one of the preceding claims,
**characterized in that**
further thickenings (30), which do not project from the cooling fin and/or which are formed flush with the cooling fin, that is to say in particular do not project therefrom, are formed on the cooling fins (14).

11. Electrical device according to any one of the preceding claims,
**characterized in that**
the fan (2) is surrounded at least in part by the connecting region of the fan housing (1).

## Revendications

1. Appareil électrique, en particulier onduleur, en particulier convertisseur,
l'appareil électrique comportant un dissipateur thermique et un ventilateur (2),
le ventilateur (2) étant au moins partiellement entouré par une zone de base d'un boîtier de ventilateur (1),
le boîtier de ventilateur (1) comportant une zone de guidage (13) pour un câble (10), en particulier un câble d'alimentation du ventilateur (2), reliée à la zone de base par une zone de liaison,
le boîtier de ventilateur (1) étant réalisé en une seule pièce, en particulier d'une seule pièce, avec sa zone de base, sa zone de liaison et sa zone de guidage (13), en particulier en tant que pièce moulée par injection plastique,
**caractérisé en ce que**
la zone de liaison est disposée entre la zone de base et la zone de guidage (13) et est formée en se rétrécissant de la zone de base vers la zone de guidage (13), des zones de limitation (20, 21, 22, 23) étant formées sur la zone de guidage (13), lesquelles limitent les câbles (10) reçus dans la zone de guidage (13), le matériau des zones de limitation (20, 21, 22, 23) étant disposé entre le câble (10) et le dissipateur thermique,
des ergots d'encliquetage (3,4) étant formés sur la zone de base, lesquels sont encliquetés et/ou clipsés dans une contre-dépouille (32, 33) respective,
la contre-dépouille (32, 33) respective étant formée sur une nervure (31) faisant saillie sur le dissipateur thermique,
la nervure (31) dépassant sur le dissipateur thermique dans le sens opposé à la direction d'acheminement du flux d'air acheminé par le ventilateur (2).

2. Appareil électrique selon la revendication 1,
**caractérisé en ce que**
le ventilateur (2) comporte un moteur électrique dont le rotor est monté rotatif autour de l'axe de rotation du ventilateur (2) et dont le stator est relié de manière fixe en rotation au boîtier de ventilateur (1).

3. Appareil électrique selon l'une des revendications précédentes,
**caractérisé en ce que**
dans la zone de guidage (13), le câble (10) est reçu, lequel est guidé du ventilateur (2) à travers la zone de liaison et à travers la zone de guidage (13) vers un élément de connecteur (6) et est en particulier relié électriquement à celui-ci,
l'élément de connecteur (6) étant monté sur une carte de circuit imprimé (7) de l'appareil électrique fixée sur le dissipateur thermique, en particulier vissée au moyen d'une vis.

4. Appareil électrique selon l'une des revendications précédentes,
**caractérisé en ce que**
sur la zone de base, une zone de languette (8) faisant saillie axialement est formée, laquelle comporte un trou traversant, à travers lequel une zone d'épaississement (9) faisant saillie, formée sur une nervure de refroidissement, traverse.

5. Appareil électrique selon l'une des revendications précédentes,
**caractérisé en ce que**
sur la zone de guidage (13), une zone de languette (12), en particulier dans la direction axiale, dépasse, un bossage (11), en particulier un bossage (11)faisant saillie sur le dissipateur thermique, traversant la zone de languette.

6. Appareil électrique selon l'une des revendications précédentes,
**caractérisé en ce que**
sur la zone de guidage (13), un ergot d'encliquetage (5), en particulier un ergot d'encliquetage (5) déformable élastiquement parallèlement à l'axe de rotation du ventilateur (2), est formé,
l'ergot d'encliquetage (5) s'engageant dans une contre-dépouille (32, 33) formée sur un bord (34) du dissipateur thermique.

7. Appareil électrique selon l'une des revendications précédentes,
**caractérisé en ce que**
le ventilateur (2) est formé en tant que ventilateur axial et le flux d'air acheminé par le ventilateur (2) est orienté le long des nervures de refroidissement (14).

8. Appareil électrique selon l'une des revendications précédentes,
**caractérisé en ce que**
l'ergot d'encliquetage (5) formé sur la zone de guidage (13) est clipsé dans la direction axiale, en particulier dans la contre-dépouille (32, 33) du bord (34),
les ergots d'encliquetage (3, 4) formés sur la zone de base étant clipsés dans une direction perpendiculaire à la direction axiale, en particulier sur le bord (34) faisant saillie sur le dissipateur thermique.

9. Appareil électrique selon l'une des revendications précédentes,
**caractérisé en ce que**
la zone de languette formée sur la zone de base dépasse dans la direction axiale et la zone de languette formée sur la zone de guidage (13) dépasse dans la direction axiale.

10. Appareil électrique selon l'une des revendications précédentes,
**caractérisé en ce que**
d'autres épaississements (30) sont formés sur les nervures de refroidissement (14), lesquels ne dépassent pas de la nervure de refroidissement et/ou lesquels sont formés affleurant à la nervure de refroidissement, en particulier donc ne dépassent pas.

11. Appareil électrique selon l'une des revendications précédentes,
**caractérisé en ce que**
le ventilateur (2) est au moins partiellement entouré par la zone de liaison du boîtier de ventilateur (1).
